# EUROPEAN PATENT APPLICATION

(11) **EP 3 540 778 A1**
(43) Date of publication of application: **18.09.2019**
(21) Application number: 18174259.4
(22) Date of filing: 25.05.2018
(51) Int. Cl.: H01L 29/06, H01L 29/78, H01L 29/739, H01L 29/417, H01L 29/08, H01L 29/47, H01L 27/07

(54) **A SEMICONDUCTOR DEVICE, COMPRISING AN INSULATED GATE FIELD EFFECT TRANSISTOR CONNECTED IN SERIES WITH A FIELD EFFECT TRANSISTOR**

(30) Priority: 16.03.2018 SE 1850300
(71) Applicant: K. Eklund Innovation, 753 27 Uppsala (SE)
(72) Inventor: Eklund, Klas-Håkan, 753 27 UPPSALA (SE); VESTLING, Lars, 151 39 SÖDERTÄLJE (SE)
(74) Representative: Noréns Patentbyrå AB

(57) **Abstract**

A semiconductor device, comprising an insulated gate field effect transistor (1) connected in series with a field effect transistor (2), FET, wherein the FET (2) comprises several parallel conductive layers (n1-n5, p1-p4), and wherein a substrate (11) is arranged as the basis for the semiconductor device, stretching under both transistors (1, 2), and a first n-type layer (n1) is arranged stretching over the substrate (11), and further wherein on top of this first n-type layer (n1) are arranged several conductive layers with channels formed by several n-type doped epitaxial layers (n2-n4) with p-type doped gates (p1-p4) on both sides.

## Description

The present invention relates to a semiconductor device comprising an insulated gate field-effect transistor connected in series with a field effect transistor with improved voltage and current capability, especially a device having a very low on-resistance.

An insulated gate field-effect transistor, such as a MOSFET, internally in silicon connected in series with a JFET has now long been the workhorse of the industry for combining high voltage power devices on the same chip as low voltage analogue and digital functions.

For improving voltage and current capability the evolution has gone from a single sided JFET to a symmetric JFET reducing the on-resistance to half, as obtained e.g. by the US patent No 4,811,075 A, describing an insulated-gate, field-effect transistor and a double-sided, junction-gate field-effect transistor connected in series on the same chip to form a high-voltage MOS transistor, and further developments having a JFET with 2 channels in series further reducing the on-resistance by 30%, as shown in US patent No. 5,313,082 A.

The latest patent has been further improved by US patent No. 6,168,983 B1, suggesting a JFET with several conductive layers in parallel implemented vertically in the substrate in a common N-well or in an N-type epi layer on top of the substrate. Later it has also been shown that if the serial connection of the insulated gate field-effect transistor and JFET is made externally further reduction of the on-resistance can be made, performance improved at high frequencies, and reliability enhanced, as e.g. described in US patent No. 8,264,015 B2. In this patent is also proposed several parallel JFET channels are implemented in a common N-well in series with an insulated gate field-effect transistor of which the size can be optimized for matching the numbers of JFET channels. Due to the external connection this can not be made in US patent No. 6,168,983 B1, as the connection is internal in silicon.

The number of parallel conductive layers is practically set by the insulated gate transistor and further by the depth of the N-well, set to 15µm in the patent. A similar limitation is also present in US patent No. 8,264,015 B2, set by implantation energy.

The proposed concept to create multiple conductive layers with ion-implantation has not been that successful as expected, due to very high energy implantation which is a fundamental limitation as noted earlier.

Other limiting problems are radiation damage lowering the mobility and the broadening of the profile of the implanted atoms. State of the art is still 2-3 conductive layers in parallel, e.g. according to Don Disney et al High-Voltage Integrated Circuits: History, State of the Art, And Future Prospects. IEEE Transactions on Electron Devices, Vol.64. No.3, March 2017*.*

In the present approach is proposed that the conductive is made by epitaxial layers with much better control, no radiation damage. Further As can used as dopant instead of P in ion-implantation which gives higher mobility. With the epitaxial technique there is no fundamental limitation to the number of conductive layers which can made in parallel.

As the resistance of the conductive layers is known, an estimation of the performance can easily be done as figure of merit Ron*A for a device:
For 6-8 conductive layers is obtained:
For a 230V device Ron*A is around 100 mΩmm² as compared to state of the art of 500 mΩmm²
For a 700V device Ron*A is around 2 Ω*mm² as compared to state of the art 15 Ω*mm², e.g. according to Don Disney et al High-Voltage Integrated Circuits: History, State of the Art, And Future Prospects. IEEE Transactions on Electron Devices, Vol.64. No.3, March 2017*.*

Area advantage means of course less cost but also drastically reduced capacitances, for increased switching speed and much higher efficiency. Even at 1200 V there is a real opportunity to compete with vertical power MOS devices and SiC devices.

All this with a modest number of parallel conductive layers of 6-8. The number of layers can easily be increased, as there are no fundamental limitations, only practical.

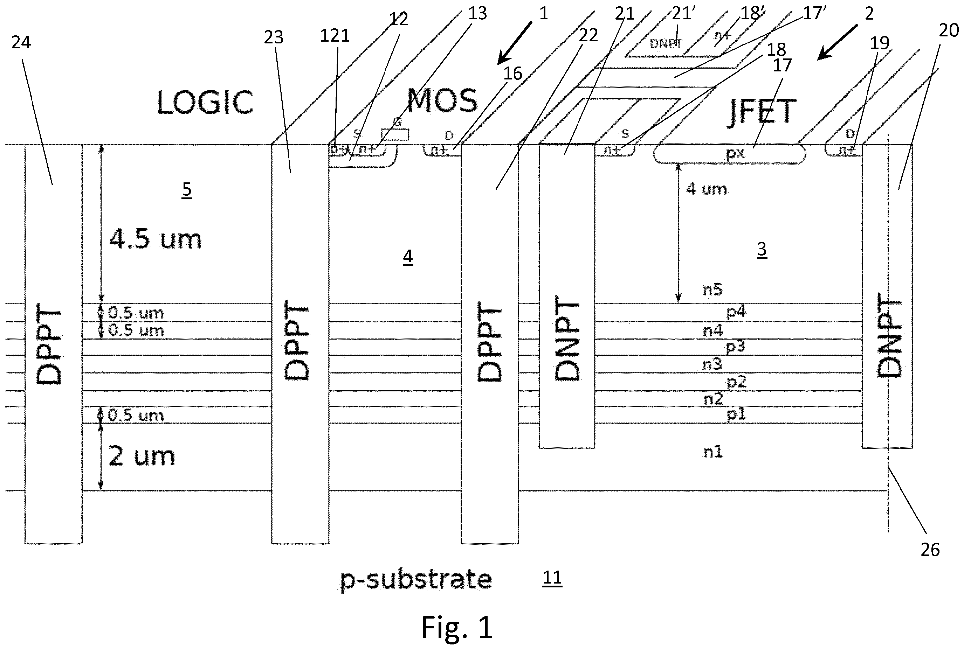

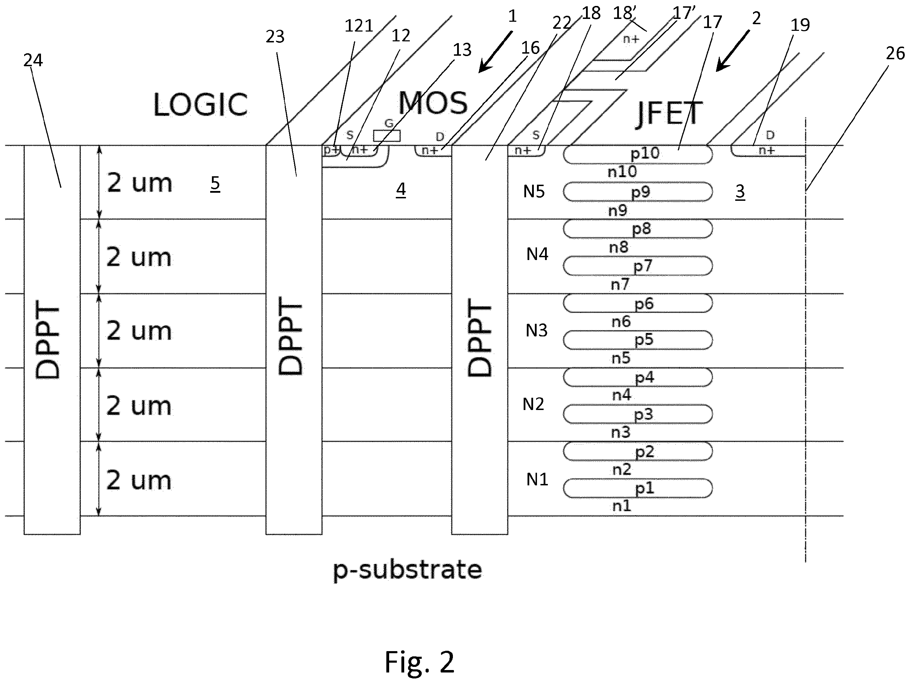

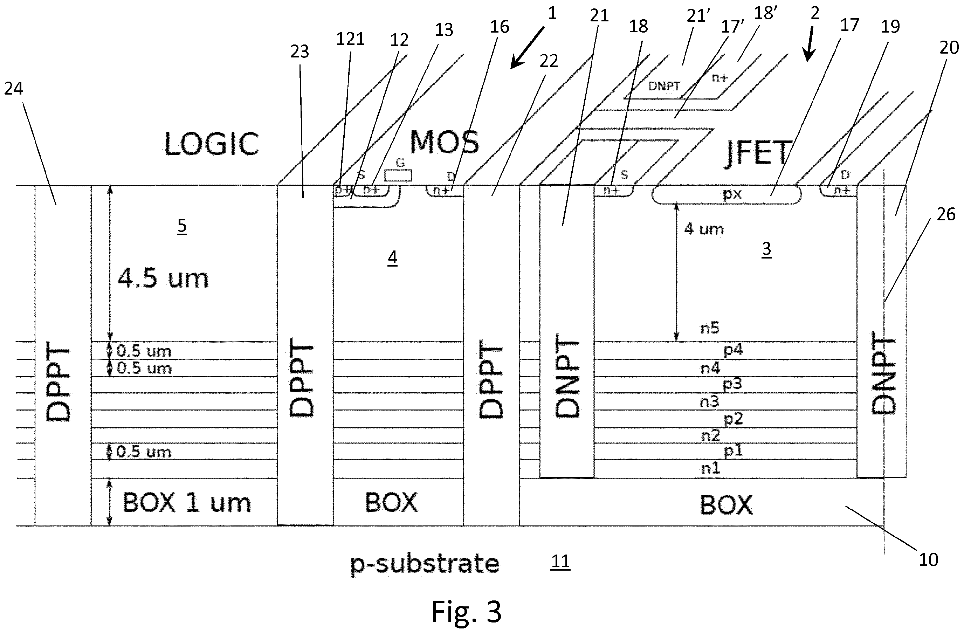

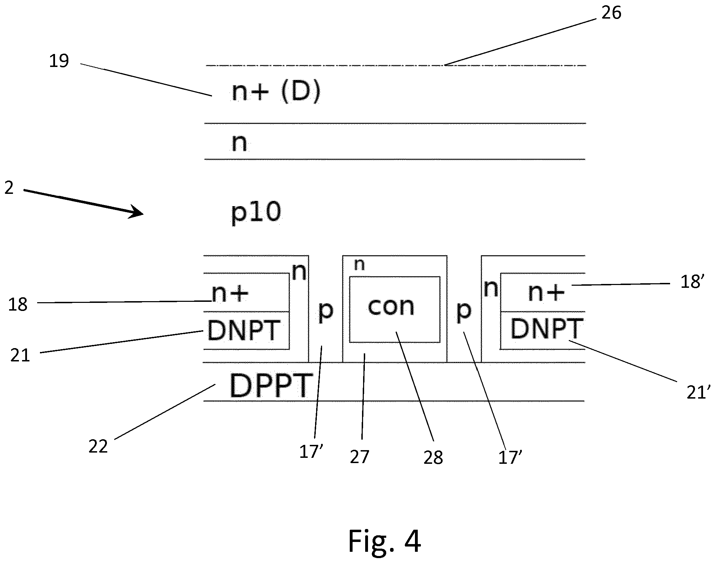

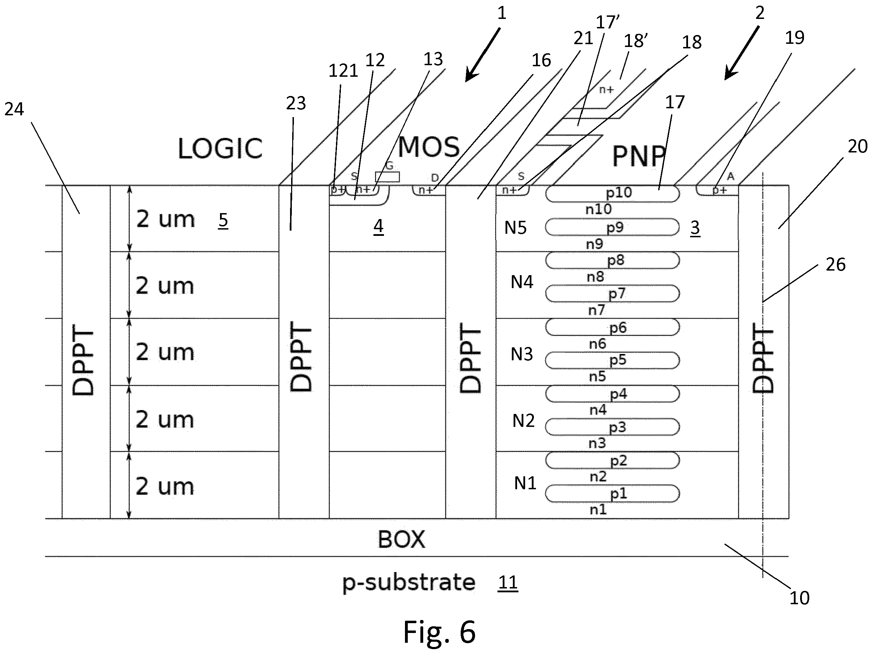

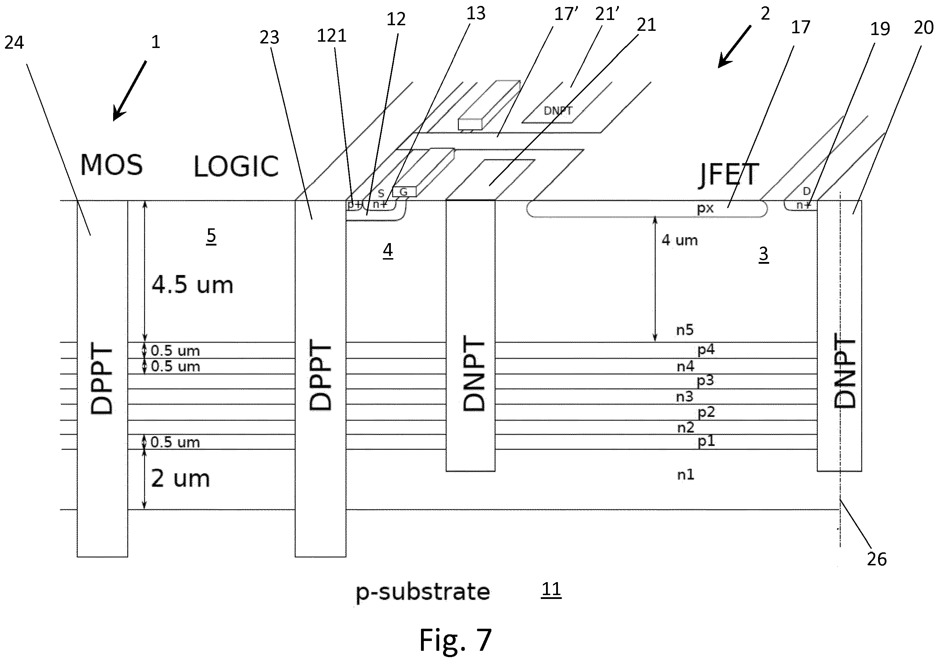

The invention will now be explained further with a help of a couple of non-limiting embodiments, shown on the accompanying drawings, in which **Fig. 1** schematically shows a first embodiment of a semiconductor device according to the invention in the form of a MOS transistor in series with a JFET comprising several conductive layers, **Fig. 2** shows a second embodiment of a semiconductor device according to the invention in the form of a MOS transistor in series with a JFET comprising several conductive layers, with two implanted p-layers in each epitaxial layer, **Fig. 3** shows an implementation of a device similar to Fig. 1 in a SOI technology with a BOX layer, **Fig. 4** shows another optional gate implantation mask for creating a Schottky diode in parallel with the drain to ground for a device according to Fig. 1 or Fig. 3, **Fig. 5** shows an optional gate implantation mask for creating a Schottky diode in parallel with the drain to ground for a device according to Fig. 2, **Fig. 6** shows a LIGBT device based on the device according to Fig. 2 implemented on SOI where the doping of the drain has been changed to p+, and being placed in contact with a DPPT creating a latch-free LIGBT, and **Fig. 7** shows a classic LDMOS device where the MOS and the JFET are in the same n-area being formed from a device in Fig. 1 where the MOS transistor is in an isolated n-area versus the JFET .

In Fig. 1 is shown a MOS transistor 1 to the left in serial connection with a JFET 2 to the right, which JFET 2 comprises several conductive layers, JFET channels, formed by parallel n-layers n1-n5 as shown in the figure and separated by common p-layers p1-p4, gates. The layers are deposited in situ in an epitaxial reactor or in two reactors where the n-layers are deposited in one and the p-layer in the other reactor. If two reactors are used, it would be a great advantage if the wafers are transported from one to the other under vacuum through interlocks. The first layer starts on top of a p-type substrate, with a resistivity ranging from 10 Ωcm to 135 Ωcm. The thickness and the doping of the layers are determined by the resurf principle, which means that the product of the thickness and doping of a layer should be around 2*10¹² charges/cm², which means thickness and doping can be varied as long this condition is satisfied.

The first channel region in the figure is chosen to be 2 µm thick with a doping of 1*10¹⁶/cm³, and then satisfies the condition above. The thickness and doping of the following layers are then chosen to be 0.5 µm with a doping of 4*10¹⁶/cm³ and could actually be as many as one like.

As a practical example the number of parallel n-layers n1-n5 is stopped before an n5 epitaxial layer which is made thicker, 4.5 µm, and has a masked implanted px layer 17 as an upper gate with thickness of 0.5 µm and charge of 1*10¹²/cm². The px layer 17 is just acting as gate for the first channel, which makes the channel layer 4 µm thick and having a doping density of 5*10¹⁵/cm³. The channel layers on the drain side is connected together with a deep N-poly trench, DNPT, 20, and so also the channel layers on the source side by a deep N-poly trench, DNPT, 21. The JFET 2 is isolated by a deep P-poly trench, DPPT 22, and on the same time connecting the p-layers p1-p4 which normally will be grounded and with given intervals abrupt the source DNPT for contacting p-layers p1-p4 in the other direction. In addition to the so formed isolated region 3 of the JFET 2 an additional DPPT 23, can create isolated n-islands, for example 4 and 5 in the figure.

The px layer 17 will preferably be grounded by px fingers 17' bringing the layer in contact with the DPPT layer 22 in the same area where the DNPT 21 is abrupted and the n+ source 18, 18' contacting will be disrupted.

Within or partly within an isolated n-region 4 for the MOS transistor 1 a body region 12 of first conductivity type, for example p-type material, is arranged and doped at between 1*10¹⁷ and 1*10¹⁸ atoms per cm³. The body region 12 typically extends to a depth of 1 µm or less below the surface of the device. Within the body region 12 for the MOS transistor 1 a source region 13 of second conductivity type, for example n+ type material doped at between 1*10¹⁸ and 1*10²⁰ atoms per cm³, is arranged. The source region 13 extends for example 0.4 µm or less below the surface of the device. A body contact region 121 in the body region 12 to the left of source region 13 of first conductivity type doped at between 1*10¹⁸ and 1*10²⁰ atoms per cm³. The body contact region 121 extends for example 0.4 µm or less below the surface of the device. Both the body region 12 and the body contact region 121 may be electrically connected to the substrate by extending the body region 12 and the body contact region 121 outside a pocket region formed.

A drain contact region 16 for the MOS transistor 1, of second conductivity type, for example n+ type material, is doped at between 1*10¹⁸ and 1*10²⁰ atoms per cm³. The drain contact region 16 extends, for example 0.4 µm or less below the surface of the device.

Within the isolated region 3 for the JFET 2 a source region 18 and a drain region 19 of second conductivity type, for example n+ type material doped at 1*10¹⁸ and 1*10²⁰ atoms per cm³. The source region 18 and the drain region 19 extends for example 0.4 µm or less below the surface of the device.

The drain contact 16 of the MOS transistor 1 will be electrically contacted to the source contact 18 of the JFET 2 and thus constitute a MOS transistor 1 in series with a JFET 2.

The breakdown voltage of the device will be determined by the drift region LD, between source region 18 and drain region 19 of the JFET 2, and the substrate resistivity.

Several isolated regions 5 can easily be made as example for logic and analogue control functions.

The device can preferably be made symmetric, with a mirror to the right in the drawing, wherein 26 denotes the symmetry line.

Fig 2 shows a MOS transistor 1 in serial connection with a JFET 2 which comprises several conductive layers, JFET channels in parallel, conductive n-layers in the figure 2, and separated by patterned common p-layers, gates.

A first n-type epitaxial layer with a thickness of 2µm is grown on top of a p-substrate resistivity ranging from 10 Ωcm to 135 Ωcm. The wafer is taken out of the reactor and 2 conductive layers are formed, n1 and n2, by the implanted gate layers p1 and p2.

The thickness and the doping of the layers are determined by the resurf principle which means that the product of the thickness and doping of a layer should be around 2*10¹² charges/cm², which means thickness and doping can be varied as long this condition Is satisfied.

The first channel region in the figure, n1, is chosen to be 0.5 µm thick with a doping of 4*10¹⁶/cm³ and then satisfies the condition above.

The thickness and doping of the following layers are then chosen to be 0.5 µm with doping 4*10¹⁶/cm³ and could actually be as many as one like.

As a practical example 5 epitaxial layers N1-N5 are deposited of which each has two implanted p-layers.

The channel layers on the drain side are connected together to the n+drain implantation 3 in the surface. The channel layers on the source side are connected together to the n+drain implantation 3 in the surface.

The JFET 2 is isolated with deep p-poly trenches, DPPT, 22, 25, on each side. The DPPT 22 on the source side has fingers connecting the p-layers, p1-p10, at given intervals.

The upper p10 gate layer 17 will be put in a contact with the DPPT layer through a finger 17' in the mask creating an area where the n+ source 18, 18' contacting is disrupted. The same mask will be used for creating and contacting all other gate layers. The fingers 17' will make sure that all n layers are in contact.

Within or partly within the isolated n-region body region of first conductivity type, for example p-type material, is doped at between 1*10¹⁷ and 1*10¹⁸ atoms per cm³. The body region 12 typically extends to a depth of 1 µm or less below surface of the device.

Within the body region 12 for the MOS transistor 1 a source region 13 of second conductivity type, for example n+type material doped at 1*10¹⁸ and 1*10²⁰ atoms per cm³. The source region 13 extends for example 0.4 µm or less below the surface of the device. A body contact region 121 in the body region 12 to the left of source region of first conductivity type doped at between 1*10¹⁸ and 1*10²⁰ atoms per cm³. The body contact region 121 extends for example 0.4 µm or less below the surface of the device. The both body region 12 and the body contact region 121 may be electrically connected to the substrate by extending the body region 12 and body contact region 121 outside the pocket region.

A drain contact region 16 of second conductivity type, for example n+ type material, is doped at between 1*10¹⁸ and 1*10²⁰ atoms per cm³. Drain contact region 16 extends, for example 0.4 µm or less below the surface.

Within the isolated region 3 for the JFET a source region 18 and a drain 19 of second conductivity type, for example n+ type material doped at 1*10¹⁸ and 1*10²⁰ atoms per cm³. The source region 18 and the drain region 19 extends for example 0.4 µm or less below the surface.

The drain contact 16 of the MOS transistor 1 will be electrically contacted to the source contact 18 of the JFET 2 and thus constitute a MOS transistor 1 in series with a JFET 2.

The breakdown voltage of the device will be determined by the drift region LD and the substrate resistivity.

As several isolated regions can easily be made as example 5 for logic and analogue control functions.

Fig. 3 shows a MOS transistor 1 in serial connection with a JFET 2 which comprises several conductive layers, JFET channels in parallel n-layers n1-n5 in the figure and separated by common p-layers p1-p4, gates. The layers are deposited in situ in an epitaxial reactor on top of an oxide layer 10, which is carried by a p- substrate 11. On the top of the oxide layer 10 there is a thin crystalline seed layer before starting growing the epitaxial layers n1-n5, p1-p4.

The thickness and the doping of the layers are determined by the resurf principle which means that the product of the thickness and doping of a layer should be around 2*10¹² charges/cm², which means thickness and doping can be varied as long this condition is satisfied.

In the figure the epitaxial layers are started with equal thickness 0.5 µm and a doping of 4*10¹⁶/cm³ and could actually be as many as one like.

As a practical example the number of epitaxial layers is stopped before the n5 epitaxial layer, which is made thicker 4.5 µm, and has a masked implanted px layer 17 as an upper gate, with a thickness of 0.5 µm and a charge of 1*10¹². The implanted px layer is just acting as gate for one channel which makes the channel layer 4 µm thick and with a doping density of 5*10¹⁵/cm³.

The Px gate layer 17 will be contacted 17' to DPPT 22 in the same way as for the device in Fig. 1.

The channel layers n1-n5 on the drain side are connected together with a deep N-poly trench, DNPT 20, and so also the channel layers on the source side by a deep N-poly trench, DNPT 21. The JFET 2 is isolated by a deep p-type poly trench, DPPT 22, and on the same time connecting the p-layers p1-p4, which normally will be grounded and with given intervals disrupt the source DNPT 21 for contacting p-layers p1-p4 in the other direction. In addition to the isolated region 3 additional DPPTs 23, 24 can create isolated n-islands for example, 4 and 5 in the figure.

Within or partly within the isolated n-region 4 a body region 12 of a first conductivity type, for example p-type material, is doped at between 1*10¹⁷ and 1*10¹⁸ atoms per cm³. The body region 12 typically extends to a depth of 1 mm or less below surface of the device. Within the body region 12 for the MOS transistor 1 a source region 13 of a second conductivity type, for example n+ type material doped at 1*10¹⁸ and 1*10²⁰ atoms per cm³. The source region 13 extends for example 0.4 µm or less below the surface of the device. A body contact region 121 in the body region 12 to the left of the source region 12 of first conductivity type is arranged, and doped at between 1*10¹⁸ and 1*10²⁰ atoms per cm³. The body contact region 121 extends for example 0.4 µm or less below the surface of the device. Both the body region 12 and the body contact region 121 may be electrically connected to the substrate by extending the body region 12 and body contact region 121 outside the pocket region.

A drain contact region 16 of the second conductivity type, for example n+ type material, is doped at between 1*10¹⁸ and 1*10²⁰ atoms per cm³. The drain contact region 16 extends, for example 0.4 µm or less below the surface of the device.

Within the isolated region 3 for the JFET 2 a source region 18 and a drain region 19 of the second conductivity type, for example n+ type material, doped at 1*10¹⁸ and 1*10²⁰ atoms per cm³. The source region 18 and the drain region 19 extends for example 0.4 µm or less below the surface of the device.

The drain contact 16 of the MOS transistor 1 will be electrically contacted to the source contact 18 of the JFET 2 and thus constitute a MOS transistor 1 in series with a JFET 2. The breakdown voltage of the device will be determined by the drift region LD.

Several isolated regions 5 can easily be made as example for logic and analog control functions.

In the embodiment shown and described in relation to Fig. 3 the epitaxial layers are on top of an oxide layer 10. Such an implementation could also be provided together with the embodiment shown and described in relation to Fig. 2, where the p-layers are implanted in the epitaxial n-layers.

A high voltage Schottky diode in parallel with the drain and ground can easily be implemented internally.

The Px finger 17' in Fig. 1 is split into two, see Fig. 4, creating a n-type surface 27 area in the middle and this contacting 28 with a Schottky metal or silicide will create a Schottky diode in parallel with the PN junction. A high performance diode is very important in many motor applications where the diode is forward biased and generate a lot of parasitic power when switched back to normal reverse condition. The diode is too slow and an integrated Schottky diode will solve that problem. It will not be necessary to use external diodes.

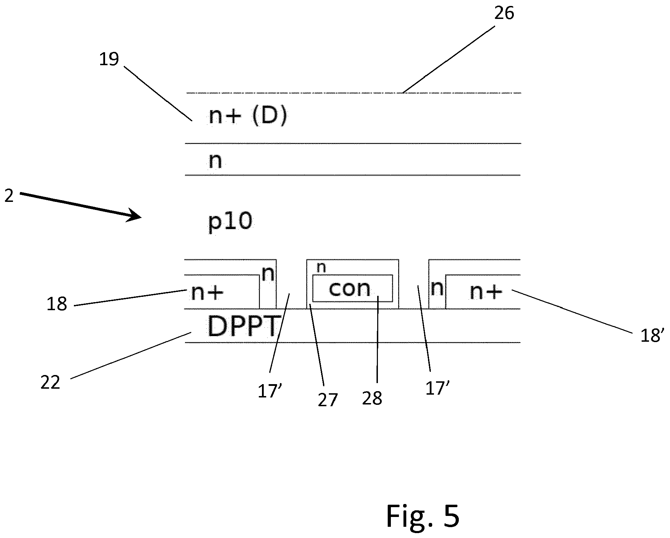

A corresponding device is formed by using the device in Fig. 2 and splitting the p10 finger into two, see Fig. 5, creating a n-type surface 27 area in the middle and this contacting 28 with a Schottky metal or silicide will create a Schottky diode in parallel with the PN junction.

A Lateral LIGBT is a combination of a MOS transistor and a lateral PNP transistor where the MOS transistor drive the base of the PNP transistor. The device is prone to Latch-up which limits its current capability. In a conventional device the MOS transistor and lateral pnp are made in the same N-well (N-Area). By splitting the devices, a latch-free LIGBT can be generated with a dramatic increased current capability. See US patent No. US 8,264,015 B2

In Fig. 6 the device in FIG 2 is implemented on SOI where the doping of the drain 19 has been changed to p+ and placed in contact with a DPPT 20. This will form a lateral PNP transistor where emitter is the p+ connected DPPT 20, the base are all conductive n-layers connected to the base contact. Collector is all gate-layers connected to DPPT 20. As the base is fed by the external MOS transistor a latch-free LIGBT with many conductive N-regions has been created which drastically should increase current capability.

Fig. 7 shows a classic LDMOS which has been created by starting from the device in Fig. 1 and deleting the drain contact 16, the source contact 18 and the DPPT 22. The width of the MOS transistor is the same as the width of the JFET. The saturation current of the MOS transistor will limit the current of the device, which is of favor for higher voltage devices where the JFET limit the current. Another advantage is the area has been taken away from the device, thus forming a smaller device.

In all device which can be made symmetric, with a mirror to the right in the drawing, the reference sign 26 denotes the symmetry line.

The invention as described herein can also be modified so that an n-layer as described is replaced by a p-layer, and correspondingly that a p-layer is replaced by an n-layer.

## Claims

1. A semiconductor device, comprising:
an insulated gate field effect transistor (1) connected in series with a field effect transistor (2), FET,
wherein the FET (2) comprises several parallel conductive layers (n1-n5, p1-p4),
**characterised in that**
a substrate (11) is arranged as the basis for the semiconductor device, stretching under both transistors (1, 2),
a first n-type layer (n1) is arranged stretching over the substrate (11),
wherein on top of this first n-type layer (n1) are arranged several conductive layers with channels formed by several n-type doped epitaxial layers (n2-n4) with p-type doped gates (p1-p4) on both sides.

2. A semiconductor device according to claim 1,
**characterised in that**
the p-type doped gates are formed as epitaxial layers (p1-p4).

3. A semiconductor device according to claim 1,
**characterised in that**
the p-type doped gates (p1 and p2) are formed by ionimplantation in the first n-type doped epitaxial layer (N1) creating conductive layers (n1 and n2), and then the same procedure has been repeated after deposition of following n-type doped epitaxial layers (N2-N5).

4. A semiconductor device according to any one of the preceding claims,
**characterised in that**
channel layers (n1-n5) on a drain side (19) of the FET (2) are connected together with a deep n-poly trench (20), and that the channel layers (n1-n5) on a source side (18) of the FET (2) are connected together with a deep n-poly trench (21).

5. A semiconductor device according to any one of the preceding claims,
**characterised in that**
the field effect transistor, FET, (2) is isolated with deep p-poly trenches, DPPT, on each side.

6. A semiconductor device according to any one of the preceding claims,
**characterised in that**
a drain contact (16) of the insulated gate field effect transistor (1) is electrically contacted to a source contact (18) of the field effect transistor (2).

7. A semiconductor device according to any one of the preceding claims,
**characterised in that**
the insulated gate field effect transistor (1) is a MOS transistor (1) and that the field effect transistor is a JFET (2).

8. A semiconductor device according to any one of the preceding claims,
**characterised in that**
an uppermost layer of the device is substantially thicker than the directly underlying several parallel conductive layers, for the location of logic and analog control functions.

9. A semiconductor device according to any one of the preceding claims,
**characterised in that**
an n-layer is replaced by a p-layer and a p-layer is replaced by an n-layer.

10. A semiconductor device according to any one of the preceding claims,
**characterised in that**
the device is an integrated high speed Schottky diode, which is implemented on the source side of the JFET by contacting the n-channel layer (27) with Schottky metal (28) which is isolated from the MOS transistor.

11. A semiconductor device according to claim 4,
**characterised in that** the device is a latch-free LIGBT, in which the doping of the drain (19) of the JFET has been changed from n+ to p+, creating a lateral PNP transistor, in which the base of the PNP is fed by the MOS transistor.
